Europäisches Patentamt

**European Patent Office**

Office européen des brevets

(19)

(11) Veröffentlichungsnummer: **0 188 435**
**B1**

(12) **EUROPÄISCHE PATENTSCHRIFT**

(45) Veröffentlichungstag der Patentschrift:
31.01.90

(51) Int. Cl.⁴: **G 01 D 5/16**

(21) Anmeldenummer: 85901979.6

(22) Anmeldetag: 25.04.85

(86) Internationale Anmeldenummer:
**PCT/DE 85/00130**

(87) Internationale Veröffentlichungsnummer:
**WO 86/00986 (13.02.86 Gazette 86/4)**

(54) **MAGNETORESISTIVER SENSOR ZUR MESSUNG VON MAGNETFELDÄNDERUNGEN UND VERFAHREN ZU SEINER HERSTELLUNG.**

(30) Priorität: 20.07.84 DE 3426785

(43) Veröffentlichungstag der Anmeldung:
30.07.86 Patentblatt 86/31

(45) Bekanntmachung des Hinweises auf die Patenterteilung:
31.01.90 Patentblatt 90/5

(84) Benannte Vertragsstaaten:
DE FR GB IT

(56) Entgegenhaltungen:
EP-A- 0 057 766

**Electronic Components and Applications, Vol.5, No.3, June 1983, Eindhoven (NL), Dibbern et al.:"The magnetoresistive sensor", pages 148-153, see page 148-page 15o, column 1**

(73) Patentinhaber: **ROBERT BOSCH GMBH, Postfach 50, D-7000 Stuttgart 1 (DE)**

(72) Erfinder: **BRILL, Klaus, Neuhaldenstrasse 24, D-7015 Korntal (DE)**
Erfinder: **REINHARD, Karl-Franz, Schlesienstrasse 32, D-7102 Weinsberg (DE)**
Erfinder: **ECKARDT, Dieter, Gibitzenhofstrasse 17, D-8500 Nürnberg (DE)**
Erfinder: **HETTICH, Gerhard, Holzgraben 30, D-8501 Rosstal (DE)**
Erfinder: **SCHMID, Hans-Dieter, Kamenzerstrasse 8, D-8500 Nürnberg 60 (DE)**
Erfinder: **CONZELMANN, Gerhard, Wilhelmstrasse 37, D-7022 Leinfelden-Echterdingen (DE)**
Erfinder: **ZABLER, Erich, Brunhildstrasse 11, D-7513 Stutensee 1 (DE)**

## Beschreibung

Die Erfindung geht aus von einem magnetoresistiven Sensor zur Messung von Änderungen der in der Ebene von magnetoresistiven Messstreifen wirkenden Komponente eines Magnetfeldes nach dem ersten Teil des Patentanspruchs 1.

Aus der Zeitschrift Philips Technische Rundschau 37, Nr. 2/3, 1977/78, Seite 47 ff ist es bekannt, magnetoresistive Sensoren zur Abtastung von Magnetbändern in Leseköpfen zu verwenden. Über eine Eingabeschaltung wird mit einer Gleichspannung ein bestimmter Messstrom durch die magnetoresistiven Messstreifen geschickt. Der elektrische Widerstand des Messstreifens lässt sich nun durch eine in der Ebene des Messstreifens wirkende Komponente eines Magnetfeldes verändern, die mit der Stromrichtung im Messstreifen eine Winkel bildet (Barber-Pole-Ausführung). Beim Lesen werden die in Form kleiner magnetischer Bereiche auf dem Magnetband gespeicherten Informationen erfasst, indem der magnetoresistive Messstreifen senkrecht zum Magnetband angeordnet wird und die in der Ebene des Messstreifens aufgetretenen Schwankungen des Magnetfeldes beim Vorbeibewegen des Magnetbandes die Richtung der Magnetisierung im Messstreifen beeinflussen und damit eine Änderung des Widerstandes im Messstreifen bewirken. Mit Hilfe eines Vorwiderstandes kann über die Stromänderung ein Messsignal am Messstreifen abgegriffen werden, das über eine geeignete Ausgangsschaltung verstärkt werden muss. Zur Verstärkung der relativ schwachen Messsignale ist es erforderlich, die Verstärkerschaltung möglichst dicht an den magnetoresistiven Messstreifen anzuordnen.

Aus der EP-A 057 766 ist ein magnetoresistiver Messwandler bekannt, bei dem die magnetoresistiven Elemente an einem Magneten angebracht sind, der gemeinsam mit elektrischen Bauteilen der Eingangs- und Ausgangsschaltung des Messwandlers auf einem Substrat zu einer Hybridschaltung zusammengefasst ist (integrally mounted). Dabei werden die magnetoresistiven Elemente über Bonddrähte mit Leiterbahnen des Substrates der Hybridschaltung kontaktiert, welche die elektrische Verbindung zu den auf dem Substrat befestigten elektronischen Bauelementen der Eingangs- und Ausgangsschaltung bilden. Derartige Lösungen sind relativ aufwendig in ihrer Herstellung, da die magnetoresistiven Messstreifen und die Elektronik separat hergestellt und dann auf der Substratplatte aufgebracht und kontaktiert werden müssen. Dabei sind Bondverbindungen gegen Umwelteinflüsse sowie Schüttel- oder Stossbeanspruchungen des Messwandlers besonders störanfällig. Ausserdem werden durch die Anordnung des Magneten und der elektronischen Bauelemente auf der Substratplatte relativ grosse Abmessungen benötigt und die entsprechend langen Leiterbahnen auf der Substratplatte zwischen den Messstreifen und den elektronischen Elementen der Eingangs- und Auagangsschaltung belasten zudem die schwachen Messsignale der Sensorelemente, so dass für die Auswerteschaltung ein zusätzlicher Verstärkungsaufwand erforderlich ist.

Ferner ist es aus der Zeitschrift Electronic Components and Applications, Band 5, Nr. 3, Juni 1983, Seiten 148–153 bekannt, magnetoresistive Elemente eines Sensors in einer Brückenschaltung in Dünnfilmtechnik auf einem Halbleitersubstrat herzustellen, über Bonddrähte mit Anschlussleitern auf einer gemeinsamen Tragplatte zu kontaktieren, sowie die Kontaktierungsenden der Anschlussleiter zusammen mit den magnetoresistiven Elementen und der Tragplatte in Isolierstoff einzubetten. Ein solcher magnetoresistiver Sensor ist als separates Bauteil für verschiedene Eingangs- und Ausgangsschaltungen in diskreter Bauweise oder in Hybridschaltung zu verwenden, wodurch sich über die vorgenannten Nachteile hinaus noch weitere störanfällige Kontaktierungen ergeben.

Der Erfindung liegt die Aufgabe zugrunde, die in Dünnschichttechnik hergestellten magnetoresistiven Messstreifen eines magnetoresistiven Sensors zur Vermeidung von Störungen und Leitungsverlusten mit der Eingangs- und Ausgangsschaltung auf möglichst kleinem Raum anzuordnen.

Der erfindungsgemässe Sensor mit den Merkmalen des Patentanspruchs 1 hat den Vorteil, dass die magnetoresistiven Messstreifen mit der Eingangs- und Ausgangsschaltung ein Bauteil bilden, bei dem lange und störanfällige Verbindungsleitungen zwischen den Messstreifen und der Auswerteschaltung vermieden werden. Als weiterer Vorteil ist anzusehen, dass mit der Dünnschichttechnik zur Herstellung der magnetoresistiven Messstreifen zugleich auch die Kontaktierung mit der Eingangs- und Ausgangsschaltung in IC-Ausführung erzielt wird. Der so gebildete magnetoresistive Sensor kann ohne Bondanschlüsse als Hybrid durch automatische Fertigungsverfahren mit hoher Genauigkeit und Funktionssicherheit kostengünstig gefertigt werden. Eine vielfältige Anwendung des Sensors ist auch dadurch möglich, dass mit dem Halbleiterchip die Eingangs- und Ausgangsschaltung sowie die Messstreifen auf kleinstem Raum untergebracht werden können. Zudem kann der Sensor direkt durch die Auswerteschaltung abgeglichen werden. Gegenüber Hall-Gebern hat der magnetoresistive Sensor eine wesentlich höhere Messempfindlichkeit. Das Messsignal liegt bei Hall-Gebern im Bereich von 1 V/Tesla, bei magnetoresistiven Sensoren dagegen im Bereich von 40 V/Tesla.

Durch die in den abhängigen Ansprüchen aufgeführten Massnahmen sind vorteilhafte Weiterbildungen und Verbesserungen der im Anspruch 1 angegebenen Merkmale möglich. Dabei ist es besonders vorteilhaft, zur Erzielung eines höheren Ausgangssignals die magnetoresistiven Messstreifen in einer Brückenschaltung anzuordnen, wobei jeder der Widerstände in einem der vier Quadranten eines quadratischen Bereiches neben der IC-Schaltung auf dem Halbleiterchip aufgebracht ist. Die Widerstände der Brückenschaltung bestehen dabei jeweils aus mäanderförmig in Reihe liegenden Widerstandsbahnen. Um durch eine entgegengesetzte Widerstandsänderung an den Widerständen ein grösseres Messsignal an der Brückendiagonale zu bekommen, sind die Widerstandsbahnen eines jeden Widerstandes in der Brückenschaltung in ihrer Längsrichtung zuden Widerstandsbahnen der benachbarten Widerstände um 90° gedreht. Die Messstreifen der Widerstände werden zur Erzielung eines verwertbaren Messsignales von einer Magnetfeldkomponente durchsetzt, welche in dem quadratischen Bereich des Halbleiterchip, in dem die Messstreifen aufgebracht sind, möglichst homogen sein und einen Feldstärkewert $H > 4\ kA/m$ aufweisen soll.

Mit dem erfindungsgemässen Verfahren zur Herstellung des magnetoresistiven Sensors ist eine kostengünstige Produktion bei hoher Qualität und Funktionssicherheit möglich. Auch bei extremen Anforderungen auf den verschiedensten Einsatzgebieten, wie beispielsweise in der Kraftfahrzeugtechnik oder in der Schwerindustrie kann der erfindungsgemässe Sensor verwendet werden. Dabei bietet er den weiteren Vorteil, dass Herstellungstoleranzen bereits am Ende des Herstellungsverfahrens am bzw. im Halbleiterchip durch geeignete Abgleichmassnahmen kompensiert werden können.

Zeichnung

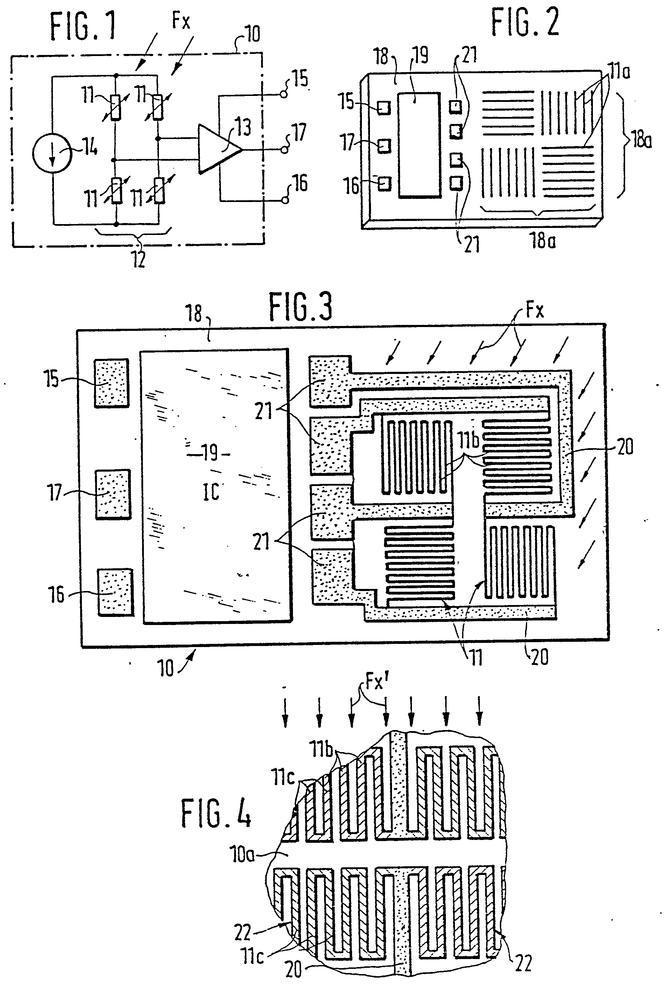

Zwei Ausführungsbeispiele der Erfindung sind in der Zeichnung dargestellt und in der nachfolgenden Beschreibung näher erläutert. Es zeigen Figur 1 einen magnetoresistiven Sensor mit vier zu einer Brückenschaltung gehörenden Messwiderständen, Figur 2 den erfindungsgemässen Halbleiterchip mit einem IC und den Messwiderständen in vergrösserter Darstellung, Figur 3 zeigt eine stark vergrösserte Darstellung des Halbleiterchip nach Figur 2 und Figur 4 zeigt stark vergrössert die Darstellung magnetoresistiver Messstreifen in Barber-Pole-Ausführung in einem Ausbruch eines Sensors.

Beschreibung der Ausführungsbeispiele

In Figur 1 ist ein erfindungsgemässer magnetoresistiver Sensor mit 10 bezeichnet, der zur Messung von Richtungsänderungen einer Magnetfeldkomponente Fx dient, welche in der Ebene von magnetoresistiven Messstreifen wirksam ist. Die Messstreifen sind hier durch vier Messwiderstände 11 dargestellt, die zu einer Brückenschaltung 12 zusammengefasst sind. Die Brückendiagonale ist auf den Eingang einer Verstärkerschaltung 13 gelegt, der die Ausgangsschaltung des Sensors 10 bildet. Die Brückenschaltung 12 liegt an einer konstanten Gleichspannungsquelle 14, welche die Eingangsschaltung des Sensors 10 bildet. Über Anschlüsse 15 und 16 ist die Eingangs- und Ausgangsschaltung 13, 14 an eine Versorgungsspannung z.B. am Bordnetz eines Kraftfahrzeuges anzuschliessen. An einer Klemme 17 ist das Messsignal des Sensors 10 am Ausgang der Verstärkerschaltung 13 abzugreifen.

Der magnetoresistive Sensor 10 ist gemäss Figur 2 auf einem Halbleiterchip 18 aus p-leitendem Silizium angeordnet. In linken Bereich ist die Eingangs- und Ausgangsschaltung 14, 13 des Sensors 10 als IC 19 in den Halbleiterchip 18 integriert. In dem rechts danebenliegndem quadratischen Bereich 18a des Halbleiterchip 18 sind die Messwiderstände 11 aus Figur 1 in Form von magnetoresistiven Widerstandsbahnen 11a in Dünnschichttechnik auf die Oberfläche des Halbleiterchip isoliert aufgebracht.

Figur 3 zeigt den Halbleiterchip 18 in stark vergrösserter Draufsicht, wobei der in den Halbleiterchip 18 integrierte IC 19 oben durch eine Schutzschicht abgedeckt ist. Dort ist auch erkennbar, dass die magnetoresistiven Widerstandsbahnen 11a aus Figur 2 jeweils zu einem der Messwiderstände 11 mäanderförmig in Reihe geschaltet sind. Sie bestehen aus einer aufgedampften Schicht aus magnetoresistivem Material, z.B. aus Permalloy. Die Enden der Messwiderstände 11 sind über Leiterbahnen 20 und Anschlüsse 21, die ebenso wie die Anschlüsse 15, 16 und 17 in Dünnschichttechnik hergestellt werden, mit den dort integrierten, nicht erkennbaren Anschlussinseln der IC-Schaltung 19 kontaktiert. Die Widerstandsbahnen 11a eines jeden Messwiderstandes 11 der Brückenschaltung 12 sind in ihrer Längsrichtung zu den Widerstandsbahnen der benachbarten Messwiderstände 11 um 90° gedreht. Dadurch wird beim Anlegen eines Magnetfeldes mit einer in der Ebene der Widerstandsbahnen 11a wirksamen Feldkomponente Fx, die mit der Richtung der Leiterbahnen 11a einen Winkel von etwa 45° bildet, durch eine Richtungsänderung dieser Magnetfeldkomponente in den Widerstandsbahnen 11a eine Widerstandsänderung hervorgerufen, die in zwei einander diagonal gegenüberliegenden Messwiderständen 11 eine Widerstandserhöhung, in den zwei anderen diagonal gegenüberliegenden Messwiderständen 11 dagegen eine Widerstandsabnahme zur Folge hat. Die Feldkomponente Fx wird dabei so gross gewählt, dass die Widerstandsbahnen 11a davon jeweils bis zur Sättigung magnetisiert sind. Dabei ergibt sich durch Verdrehen der Magnetfeldkomponente Fx an der Brückenschaltung 12 eine Messempfindlichkeit von $\Delta U / \Delta B = 40\ V/Tesla$.

Ein solcher magnetoresistiver Sensor kann als Drehzahlsensor verwendet werden, indem er zusammen mit einem Dauermagneten dicht über einem umlaufenden Flussleitstück oder einem weichmagnetischen Zahnkranz so angeordnet wird, dass der quadratische Bereich 18a des Halbleiterchip von dem Magnetfeld des Dauermagneten derart durchsetzt wird, dass sich eine starke Magnetfeldkomponente senkrecht zum Halbleiterchip 18 und eine in der Ebene der Messwiderstände 11 liegende Komponente Fx ergibt, die wesentlich kleiner ist, jedoch ausreicht, um die Widerstandsbahnen 11a unter einem Winkel von 45° bis in die Sättigung zu magnetisieren. Wird nun beim Vorbeidrehen eines Zahnes die Ma

gnetfeldkomponente Fx in ihrer Richtung verändert, so tritt an der Brückenschaltung 12 eine Messspannung auf, die im IC 19 verstärkt als Messsignal am Anschluss 17 erscheint. Die Drehzahl einer Brennkraftmaschine kann auf diese Weise durch die Zahl der Messsignale pro Zeiteinheit ermittelt werden.

In einem weiteren Ausführungsbeispiel sind bei einem Sensor 10a gemäss Figur 4 die einzelnen Widerstandsbahnen 11b durch elektrisch leitende Goldstege 22 in Bahnabschnitte 11c aufgegliedert. Die Goldstege 22 verlaufen unter einem Winkel von 45° zur Längsrichtung der Widerstandsbahnen 11b. Dadurch wird die Richtung des Stromes im Sensor um 45° gegen die Längsachse gedreht. Um mit der neuen Stromrichtung wieder einen Winkel von 45° zu erzielen, wird nunmehr die Magnetfeldkomponente Fx' in Längsrichtung der Widerstandsbahnen 11b angelegt. Um auch hier bei einer Brückenschaltung 12 gemäss Figur 1 bei Änderung der Richtung der Magnetfeldkomponente Fx' ein Messsignal zu erzielen, müssen die Goldstege 22 auf den Widerstandsbahnen 11b eines jeden Messwiderstandes 11 zu den Goldstegen 22 der benachbarten Messwiderstände 11 der Brückenschaltung 12 um 90° gedreht werden. Die Unterteilung magnetoresistiver Messstreifen durch schräg verlaufende elektrisch leitende Stege ist unter dem Namen Barber-Pole-Ausführung an sich bekannt.

Zur Herstellung eines magnetoresistiven Sensors 10 nach Figur 3 ist es erforderlich, dass in einem ersten Verfahrensabschnitt zunächst die Eingangs- und Ausgangsschaltung als IC 19 in den Halbleiterchip 18 integriert wird. Danach wird die gesamte Oberfläche des Halbleiterchip 18 mit Ausnahme der noch zu kontaktierenden Anschlüsse mit einer Oxidschicht abgedeckt. Anschliessend werden die Messwiderstände 11 in Dünnschichttechnik neben dem IC 19 auf den Halbleiterchip 18 aufgebracht und schliesslich werden die Messwiderstände 11 über die ebenfalls in Dünnschichttechnik herzustellenden Leiterbahnen 20 mit den Anschlüssen 21 am IC 19 kontaktiert. Dabei werden zugleich die Anschlüsse 15, 16 und 17 des Sensors 10 mit hergestellt. Für die Herstellung eines magnetoresistiven Sensors 10a nach Figur 4 werden in einem weiteren Verfahrensschritt die zu einer Brückenschaltung 12 vereinigten Widerstandsbahnen 11b mit den Goldstegen 22 bedampft, wobei gegebenenfalls diese Goldstege 22 noch galvanisch verstärkt werden können.

**Patentansprüche**

1. Magnetoresistiver Sensor zur Messung von Änderungen der in der Ebene von magnetoresistiven Messstreifen wirksamen Komponente eines Magnetfeldes, die mit der Stromrichtung im Messstreifen einen Winkel bildet und wobei die Messstreifen mit einer auf einem Substrat angeordneten Eingangs- und Ausgangsschaltung zur Erzeugung eines Messsignals verbunden sind, die gemeinsam mit den Messstreifen zu einer Einheit zusammengefasst und mit den Messstreifen kontaktiert ist, dadurch gekennzeichnet, dass die Eingangs- und Ausgangsschaltung als IC (19) in einem Bereich eines als Substrat verwendeten Halbleiterchips (18) monolithisch integriert ist und dass die magnetoresistiven Messstreifen (11a, b) in Dünnschichttechnik in einem anderen Bereich des Halbleiterchips (18) auf diesen isoliert aufgebracht und über Leiterbahnen (20) des Halbleiterchips (18) mit der monolithischen IC-Schaltung (19) kontaktiert sind.

2. Sensor nach Anspruch 1, dadurch gekennzeichnet, dass die magnetoresistiven Messstreifen (11a, b) aus vier in einer Brückenschaltung miteinander und mit der IC-Schaltung (19) verbundenen Messwiderständen (11) bestehen, die in den vier Quadranten eines quadratischen Bereichs (18a) auf dem Halbleiterchip (18) derart aufgebracht sind, dass die Widerstandsbahnen (11a) eines jeden Messwiderstandes (11) der Brückenschaltung (12) in ihrer Längsrichtung zu den Widerstandsbahnen (11b) der benachbarten Messwiderstände (11) um 90° gedreht sind.

3. Sensor nach Anspruch 2, dadurch gekennzeichnet, dass die Messwiderstände (11) der Brückenschaltung (12) aus mäanderförmig in Reihe liegenden Widerstandsbahnen (11a, 11b) bestehen.

4. Verfahren zur Herstellung eines magnetoresistiven Sensors nach Anspruch 1, dadurch gekennzeichnet, dass in den Halbleiterchip (18) zunächst die Eingangs- und Ausgangsschaltung als IC (19) monolithisch integriert wird, dass danach die Oberfläche des Halbleiterchips (18) durch eine Isolierschicht abgedeckt, anschliessend die magnetoresistiven Messstreifen (11a, 11b) in Dünnschichttechnik hergestellt und schliesslich Leiterbahnen (20) und Anschlüsse (15, 16, 17, 28) in Dünnschichttechnik hergestellt und so gestaltet werden, dass die Messstreifen (11a, 11b) mit der IC-Schaltung (19) dadurch kontaktiert werden.

5. Verfahren nach Anspruch 4, dadurch gekennzeichnet, dass die gemäss Anspruch 2 zu einer Brückenschaltung (12) vereinigten Messstreifen (11b) derart mit Goldstegen (22) bedampft werden, dass sie unter 45° zur Längsrichtung der Messstreifen (11b) verlaufen und diese in Bahnabschnitte (11c) so aufgliedern, dass die Bahnabschnitte (11c) der benachbarten Messwiderstände (11) um 90° gedreht sind.

6. Verfahren nach Anspruch 5, dadurch gekennzeichnet, dass die aufgedampften Goldstege (22) galvanisch verstärkt werden.

**Claims**

1. Magnetoresistive sensor for measuring changes in the component of a magnetic field which is active in the plane of magnetoresistive sensing strips, which component forms an angle with the direction of the current in the sensing strip and in which arrangement the sensing strips are connected with an input and output circuit arranged on a substrate for generating a measurement signal, which, together with the sensing strips, are combined to form one unit and are brought into contact with the sensing strips, characterized in that the input and output circuit is monolithically integrated as IC (19) in an area of a semiconductor chip (18) used as substrate and in that the magnetoresistive sensing strips (11a, b) are applied in thin-film technique in another area of the semiconductor chip (18) insulated on the latter and are brought into contact with the monolithic IC circuit (19) via conductor tracks (20) of the semiconductor chip (18).

2. Sensor according to Claim 1, characterized in that the magnetoresistive sensing strips (11a, b) consist of four sensing resistors (11) which are connected in a bridge circuit to one another and to the IC circuit (19) and which are applied in the four quadrants of a square area (18a) on the semiconductor chip (18) in such a manner that the resistance tracks (11a) of each sensing resistor (11) of the bridge circuit (12) are rotated by 90° in their longitudinal direction with respect to the resistance tracks (11b) of the adjacent sensing resistors (11).

3. Sensor according to Claim 2, characterized in that the sensing resistors (11) of the bridge circuit (12) consist of resistance tracks (11a, 11b) which are connected in series in the form of a meander.

4. Method for producing a magnetoresistive sensor according to Claim 1, characterized in that first the input and output circuit is monolithically integrated as IC (19) in the semiconductor chip (18), that then the surface of the semiconductor chip (18) is covered by an insulating layer, subsequently the magnetoresistive sensing strips (11a, 11b) are produced in thin-film technique and finally conductor tracks (20) and connections (15, 16, 17, 28) are produced in thin-film technique and constructed in such a manner that, as a result, the sensing strips (11a, 11b) are brought into contact with the IC circuit (19).

5. Method according to Claim 4, characterized in that gold webs (22) are vapour-deposited on the sensing strips (11b) which, according to Claim 2, are combined to form a bridge circuit (12), in such a manner that they extend at 45° with respect to the longitudinal direction of the sensing strips (11b) and divide the latter into track sections (11c) in such a manner that the track sections (11c) of the adjacent sensing resistors (11) are rotated by 90°.

6. Method according to Claim 5, characterized in that the vapour-deposited gold webs (22) are galvanically reinforced.

**Revendications**

1. Capteur magnétorésistif pour mesurer les variations de la composante d'un champ magnétique agissant dans le plan de bandes magnétorésistives, formant un angle avec la direction du courant dans les bandes de mesure et les bandes de mesure sont reliées à un circuit d'entrée et un circuit de sortie prévu sur le substrat pour créer un signal de mesure, ces circuits étant réunis en commun avec les bandes de mesure pour former un ensemble et être en contact avec les bandes de mesure, capteur caractérisé en ce que les circuits d'entrée et de sortie sont réalisés sous forme de circuits intégrés (19), monolithiques dans une zone d'une plaquette semi-conductrice (18) utilisée comme support et en ce que les bandes magnétorésistives (11a, b) sont réalisées de manière isolée dans une autre zone de la plaquette semi-conductrice (18) selon la technique des couches minces, et sont mises en contact avec le circuit monolithique intégré (19) par les chemins conducteurs (20) de la plaquette semi-conductrice (18).

2. Capteur selon la revendication 1, caractérisé en ce que les bandes de mesure magnétorésistives (11a, b) sont composées de quatre résistances de mesure (11) réunies par un montage en pont et reliées au circuit intégré (19), ces résistances de mesure étant prévues dans les quatre quadrants d'une zone carrée (18a) de la plaquette semi-conductrice (18) de façon que les bandes de résistances (11a) d'une de chaque résistance de mesure (11) du montage en pont (12) soient tournées de 90° dans leur direction longitudinale par rapport aux chemins résistants (11b) des résistances de mesure (11) voisines.

3. Capteur selon la revendication 2, caractérisé en ce que les résistances de mesure (11) du montage en pont (12) sont formées de chemins résistants (11a, 11b) disposés en méandres, en série.

4. Procédé de fabrication d'un capteur magnétorésistif selon la revendication 1, caractérisé en ce qu'on intègre d'abord de manière monolithique les circuits d'entrée et de sortie (19) dans la plaquette semi-conductrice (18), puis on recouvre la surface de la plaquette semi-conductrice (18) par une couche isolante, puis on réalise les bandes de mesure magnétorésistives (11a, 11b) selon la technique des couches minces et enfin on réalise les chemins conducteurs (20) et les branchements (15, 16, 17, 22) selon la technique des couches minces et on les forme pour que les bandes de mesure (11a, 11b) soient ainsi mises en contact avec le circuit intégré (19).

5. Procédé selon la revendication 4, caractérisé en ce que les bandes de mesure (11b) réunies en un montage en pont (12) reçoivent par vaporisation des entretoises en or (22) qui sont inclinées suivant un angle de 45° par rapport à la direction longitudinale des bandes de mesure (11b) et celles-ci sont réparties dans les segments de bande (11c) pour que les segments de bande (11c) soient tournés de 90° par rapport aux résistances de mesure voisines (11).

6. Procédé selon la revendication 5, caractérisé en ce que les entretoises en or (22) déposées à la vapeur sont renforcées par voie galvanique.

FIG.1

FIG.2

FIG.3

FIG.4